(19) Europäisches Patentamt
European Patent Office
Office européen des brevets

(11) **EP 3 584 925 B1**

(12) **EUROPÄISCHE PATENTSCHRIFT**

(45) Veröffentlichungstag und Bekanntmachung des Hinweises auf die Patenterteilung:
**19.01.2022 Patentblatt 2022/03**

(51) Internationale Patentklassifikation (IPC):
**H03F 1/30** (2006.01)          **H03F 3/45** (2006.01)
**G03F 1/00** (2012.01)

(21) Anmeldenummer: **18178839.9**

(22) Anmeldetag: **20.06.2018**

(52) Gemeinsame Patentklassifikation (CPC):
**H03F 1/30; H03F 3/45475; H03F 3/45968;**
H03F 2200/375

(54) **SCHALTUNGSANORDNUNG ZUM ERZEUGEN EINER GEREGELTEN VERSORGUNGS-KLEINSPANNUNG**

CIRCUIT ARRANGEMENT FOR GENERATING A REGULATED SMALL SUPPLY VOLTAGE

ENSEMBLE DE CIRCUIT PERMETTANT DE GÉNÉRER UNE BASSE TENSION D'ALIMENTATION RÉGLÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.12.2019 Patentblatt 2019/52**

(73) Patentinhaber: **ZKW Group GmbH**
**3250 Wieselburg (AT)**

(72) Erfinder: **Guth, Christian**
**7433 Mariasdorf (AT)**

(74) Vertreter: **Patentanwaltskanzlei**
**Matschnig & Forsthuber OG**
**Biberstraße 22**
**Postfach 36**
**1010 Wien (AT)**

(56) Entgegenhaltungen:
WO-A1-00/48011          CH-A5- 653 501
JP-A- S4 839 128          US-A- 5 097 223
US-A1- 2007 090 878

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung bezieht sich auf eine Schaltungsanordnung zum Erzeugen einer geregelten Versorgungs-Kleinspannung für einen aus zwei Betriebsspannungen asymmetrisch versorgten Operationsverstärker, wobei die Versorgungs-Kleinspannung in der Größenordnung eines Zehntel einer Betriebsspannung zwischen einem Pol einer Betriebsspannung und einem Betriebsspannungs-Eingang des Operationsverstärkers liegt. Speziell bei Operationsverstärkerschaltungen ist es notwendig, eine negative Spannung zur Verfügung zu stellen, um den Verstärker Ausgang des Operationsverstärkers auch auf null Volt regeln zu können. Selbst bei sogenannten Rail-to-Rail Operationsverstärken bleibt am Verstärkerausgang stets ein Spannungsoffset von einigen Millivolt bestehen. Auch besteht bei Schaltungen, bei welchen im Millivolt Bereich gearbeitet wird, die Gefahr, dass der Einfluss der Eingangs-Offset Spannung zu groß ist, um eine zufriedenstellende Ausgangsregelung zu ermöglichen.

Für den Fall einer notwendigen negativen Ausgangsspannung, beziehungsweise 0 V am Ausgang des Operationsverstärkers, werden typischerweise symmetrisch versorgte Operationsverstärker verwendet. Dies bedeutet zum Beispiel, dass solche Verstärker mit ± 12 Volt versorgt werden. Häufig sind für spezielle Anwendungen jedoch nur Verstärkertypen mit einem Versorgungsspannungsbereich von 5V Differenzspannung verfügbar (sogenannte High speed, high precision OPs). Bei symmetrische Versorgung würde dies bedeuten, dass die positive und negative Versorgungsspannung nur mehr ±2,5 V betragen darf. Dies kann in manchen technischen Anwendungsfällen, zum Beispiel bei der Ansteuerung von MOSFETS, nicht ausreichend sein, um die Gate-Source Threshold Spannung zu überwinden.

US5097223, WO0048011, US2007090878 zeigen einige Beispiele aus dem relevanten Stand der Technik. JPS4839128 zeigt eine Operationsverstärker-basierte Schaltung zur Offsetkompensation in der Eingangsspannung, wobei der Operationsverstärker unsymmetrisch mit zwei Betriebsspannungen versorgt wird und die Offsetkompensation durch eine Rückführung der Ausgangsspannung auf den invertierenden Eingang über eine geregelte Referenzspannungsquelle erfolgt.

Eine Aufgabe der Erfindung liegt darin, mit einfachen Mitteln eine Spannungsversorgung für einen Operationsverstärker zu schaffen, die sich auch für Operationsverstärker mit niedrigeren Betriebsspannungen eignet, welche oft als "high speed, high precision"-Typen bezeichnet werden und die im Prinzip asymmetrisch mit Spannung versorgt werden, jedoch auch eine leichte Erweiterung des Spannungsbereichs erlauben, typischerweise um 0,3 bis 0,5 Volt.

Ausgehend von einer Schaltungsanordnung der eingangs genannten Art wird diese Aufgabe mit den Merkmalen des unabhängigen Anspruchs 1 gelöst.

Bei einer zweckmäßigen Weiterbildung der Erfindung ist vorgesehen, dass zwischen den einen Pol einer Betriebsspannung und einen Betriebsspannungs-Eingang des Operationsverstärkers die gesteuerte Arbeitsstrecke eines Transistors geschaltet ist, wobei an der Steuerelektrode des Transistors eine geregelte Referenzspannungsdiode für eine Referenzspannung liegt.

Dabei kann mit Vorteil vorgesehen sein, dass der geregelten Referenzspannungsdiode zur Einstellung ihrer Führungsgröße die Ausgangsspannung eines Spannungsteilers zugeführt ist, welcher an der Arbeitsstrecke des Transistors liegt.

Weiters kann es für diesen Fall zweckmäßig sein, wenn der Spannungsteiler zusätzlich über einen Vorwiderstand an jener Betriebsspannung des Operationsverstärkers liegt, welche direkt an einem Betriebsspannungs-Eingang des Operationsverstärkers liegt.

Falls keine Einstellung der geregelten Versorgungs-Kleinspannung erforderlich ist, kann eine noch kostengünstigere Lösung gewählt werden, bei welcher die geregelte Referenzspannungsquelle eine geregelte Referenzdiode ist, die eine interne feste Führungsgröße besitzt.

Die Erfindung samt weiteren Vorteilen ist im Folgenden an Hand beispielsweiser Ausführungsformen näher erläutert, die in den angefügten Zeichnungen veranschaulicht sind. In diesen zeigen

Fig. 1 schematisch eine asymmetrische Spannungsversorgung eines 5-Volt-Operationsverstärkers nach dem Stand der Technik,
Fig. 2 schematisch eine symmetrische Spannungsversorgung eines 5-Volt-Operationsverstärkers nach dem Stand der Technik,
Fig. 3 ein erstes Ausführungsbeispiel einer Schaltungsanordnung nach der Erfindung und
Fig. 4 ein zweites Ausführungsbeispiel einer Schaltungsanordnung nach der Erfindung.

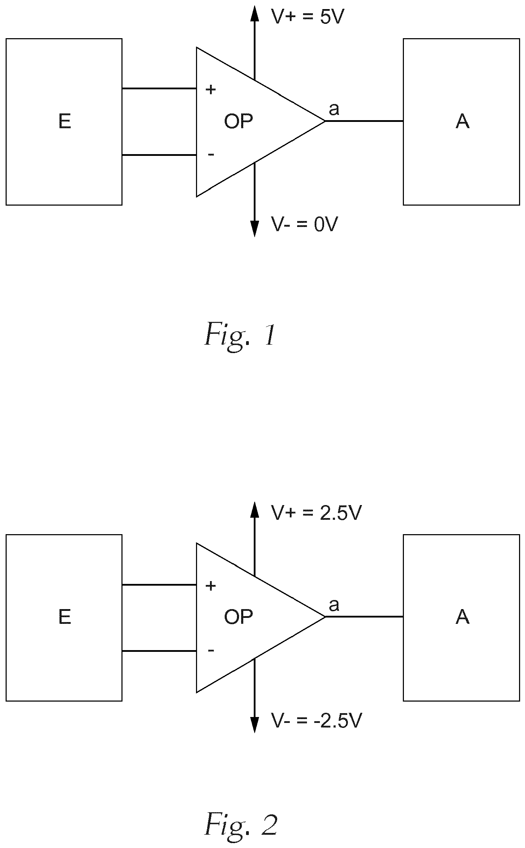

**Fig. 1** zeigt schematisch eine asymmetrische Spannungsversorgung eines 5 Volt Operationsverstärkers **OP** nach dem Stand der Technik. Der Operationsverstärkers OP besitzt zwei mit + und - bezeichnete Eingänge, einen Ausgang **a** sowie zwei mit **V+** und **V-** bezeichnete Versorgungseingänge für seine Spannungsversorgung. Eine Eingangsschaltung **E** liefert Signale an den Operationsverstärker OP, dessen Ausgang an eine Ausgangsschaltung **A** angeschlossen ist. Bei dieser asymmetrischen Spannungsversorgung liegt der Versorgungseingang V- an 0 Volt (Nullpotential) und der Versorgungseingang V+ an + 5 Volt.

**Fig. 2** zeigt in völliger Analogie zu Fig. 1 eine symmetrische Spannungsversorgung eines 5 Volt Operationsverstärkers OP nach dem Stand der Technik. Bei dieser Art der Spannungsversorgung liegt der Versorgungseingang V- an -2,5 Volt und der Versorgungseingang V+ an + 2,5 Volt.

Bevor nun auf eine erste Ausführungsform der Erfindung eingegangen wird, sei ausgeführt, dass unter dem Begriff "geregelte Referenzdiode" im Rahmen dieser Erfindung elektronische Bauteile zu verstehe sind, die im Handel erhältlich sind und eine hochgenaue stabile Referenzspannung liefern. Als Beispiele seien genannt die Bautypen TL431 und TL432 der Fa. Texas Instruments (Datenblatt siehe http://www.ti.com/lit/ds/symlink/tl432a.pdf), bei welchen die Referenzspannung über einen besonderen dritten Eingang einstellbar ist, oder die Bautypen LM113, LM313, gleichfalls von der Fa. Texas Instruments (Datenblatt siehe http://www.ti.com/lit/ds/symlink/lm113.pdf), welche wie eine übliche Zenerdiode lediglich zwei Anschlüsse und eine interne feste Führungsgröße besitzt. Diese Bauteile besitzen eine interne Regelung und können an Stelle einer üblichen Zenerdiode verwendet werden, liefern jedoch eine wesentlich genauere und beispielsweise von dem Laststrom de facto unabhängige Referenzspannung, die, wie bereits vorhin erwähnt, bei einigen Bautypen auch von außen vorgegeben werden kann.

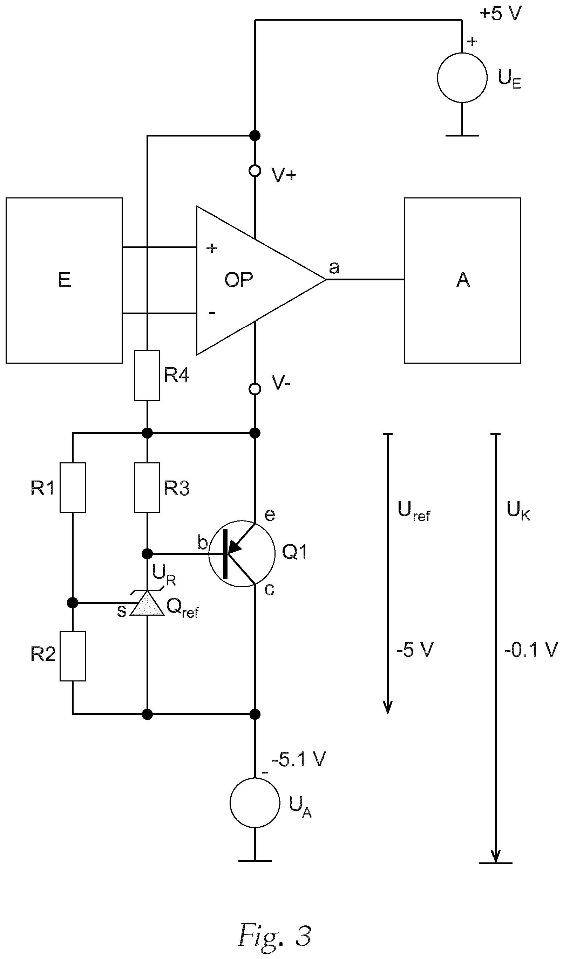

Unter Bezugnahme auf **Fig. 3** wird nun ein Ausführungsbeispiel einer Schaltungsanordnung nach der Erfindung zur Spannungsversorgung eines Operationsverstärkers OP gezeigt, der zwei mit + und - bezeichnete Eingänge, einen Ausgang a sowie zwei mit V+ und V- bezeichnete Versorgungseingänge für seine Spannungsversorgung besitzt. Eine Eingangsschaltung E liefert Signale an den Operationsverstärker OP, dessen Ausgang an eine Ausgangsschaltung A angeschlossen ist. Eingangsschaltung E und Ausgangsschaltung A unterliegen keinen Einschränkungen, wobei jedenfalls die Beschaffenheit dieser Schaltungen für die Erfindung ohne Bedeutung ist, die sich lediglich mit der Spannungsversorgung eines Operationsverstärkers beschäftigt.

Zur Realisierung der Erfindung soll der Operationsverstärker asymmetrisch versorgt werden, wobei es, wie eingangs erwähnt, möglich sein solle, den Ausgang des Operationsverstärkers zumindest auf 0 Volt oder auch auf eine leicht negative Spannung, wie beispielsweise auf 100 Millivolt, zu bringen, was nicht möglich ist, wenn man den Versorgungseingang V- einfach auf Nullpotential legt.

An dem positiven Versorgungseingang V+ des Operationsverstärkers ist im vorliegenden Beispiel eine erste Betriebsspannung $U_E$ gelegt, die hier +5 Volt beträgt. Der negative Versorgungseingang V- liegt über die Emitter-Kollektor-Strecke **e-c** eines pnp-Transistors **Q1** an dem negativen Pol einer zweiten, negativen Betriebsspannung $U_A$, die hier -5,1 Volt beträgt. Derartige Betriebsspannungen im Bereich von +/- 5 Volt werden standardmäßig von stabilisierten Netzgeräten geliefert.

Zwischen Basis b und Kollektor c des Transistors Q1 liegt eine geregelte Referenzdiode $Q_{ref}$ für eine Referenzspannung $U_R$, die im vorliegenden Fall einen Steuereingang s besitzt, über welchen eine Einstellung der geregelten Referenzspannung möglich ist. Wie bereits oben erwähnt, ist ein derartiger Steuereingang beispielsweise bei den Bautypen TL431 und TL432 der Fa. Texas Instruments vorhanden. Dem genannten Steuereingang s ist die Mittenspannung eines von Widerständen **R1** und **R2** gebildeten Spannungsteilers zugeführt, der zwischen der negativen Betriebsspannung $U_A$ und dem negativen Versorgungseingang V- des Operationsverstärkers OP liegt. Ein Widerstand **R3** liegt zwischen Emitter e und Basis b und von der positiven, ersten Betriebsspannung $U_E$ ist ein Widerstand **R4** zu dem Punkt geführt, an dem die Widerstände R1 und R3, der Emitter e und der negative Versorgungseingang V- liegen.

Bei der Schaltung nach Fig. 3 berechnet sich die gewünschte geregelte Versorgungs-Kleinspannung $U_K$, welche zwischen dem negativen Versorgungseingang V- des Operationsverstärkers OP und Masse (Nullpotential) liegt, wie folgt, wobei $U_{ref}$ die an der Emitter-Kollektor-Strecke e-c des Transistors Q1 liegende Referenzspannung ist:

$$U_K = U_A + \frac{U_{ref}}{R2} * (R1 + R2)$$

Der Vorwiderstand R4 dient dazu, eine Regelung sicherzustellen, falls der Laststrom gegen Null geht und $U_K$ nicht mehr ausgeregelt werden kann. Die Widerstände R1 und R2 dienen dazu, die Ausregelgröße $U_K$ an die Referenzdiode $Q_{ref}$ als Messgröße zurückzuführen.

Wenn die Referenzspannung $U_{ref}$ durch entsprechende Dimensionierung des Spannungsteilers R1/R2 auf 5 Volt eingestellt ist und die Versorgungsspannung $U_A$ -5,1 Volt beträgt, so ergibt sich eine Versorgungs-Kleinspannung UK von -0,1 Volt und das gewünschte Ergebnis ist erreicht.

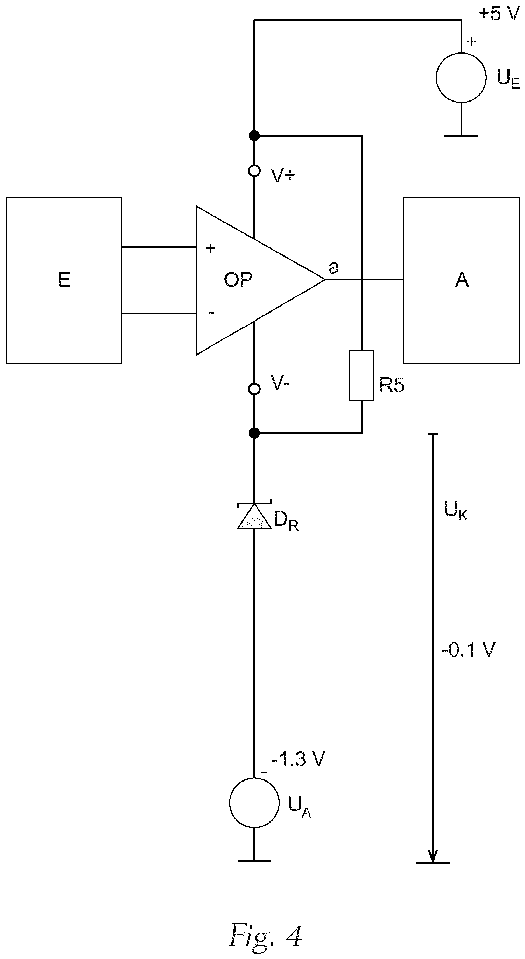

Die in Fig. 4 gezeigte Schaltung verwendet im Gegensatz zu der Schaltung nach Fig. 3 eine geregelte Referenzdiode ohne Steuereingang, somit mit einer internen festen Führungsgröße. Genauer gesagt liegt bei diesem Beispiel eine "zweipolige" Referenzdiode $D_R$ zwischen dem Versorgungseingang V- des Operationsverstärker OP und einer geregelten negativen zweiten Betriebsspannung $U_A$, im Beispiel -1,3 Volt und der positive Versorgungseingang V+ des Operationsverstärkers ist im vorliegenden Beispiel an eine erste Betriebsspannung $U_E$ gelegt, die hier +5 Volt beträgt. Von dem positiven Versorgungseingang V+ des Operationsverstärkers führt ein Widerstand R5, mit einem Wert von z.B. 1 kOhm zur Kathode der Referenzdiode $D_R$. Als Referenzdiode wird im vorliegenden Beispiel eine "Precision Reference Diode" LM 113 der Firma Texas Instruments verwendet, deren Daten über den oben angegebenen Link abrufbar sind. Mit dieser Diode ergibt sich eine Versorgungs-Kleinspannung $U_K$ von -0,1 Volt, die auch hier erwünscht ist.

Beiden Ausführungen nach Fig. 3 und Fig. 4 ist gemeinsam, dass zwischen den einen Pol einer Betriebsspannung $U_A$ und einen Betriebsspannungs-Eingang V- des Operationsverstärkers OP eine geregelte Referenzspannungsquelle für eine Referenzspannung $U_R$ geschaltet ist. Bei der Ausführung nach Fig. 3 wird eine

3

"dreipolige" Referenzdiode $Q_{ref}$ und ein von dieser angesteuerter Transistor Q1 verwendet, wobei die Referenzdiode von außen über den Steuereingang s steuerbar ist, wogegen bei der Ausführung nach Fig. 4 lediglich eine "zweipolige" Referenzdiode $\mathbf{D_R}$ Verwendung findet, die eine interne Regelung mit einer festen Bezugsgröße besitzt.

**Patentansprüche**

1. Schaltungsanordnung zum Erzeugen einer geregelten Versorgungs-Kleinspannung (Uk) für einen durch zwei Betriebsspannungen ($U_E$, $U_A$) und eine geregelte Referenzspannungsquelle asymmetrisch versorgten Operationsverstärker, umfassend den Operationsverstärker (OP),

   wobei die Versorgungs-Kleinspannung in der Größenordnung eines Zehntels einer der beiden Betriebsspannungen liegt,
   wobei die Schaltungsanordnung weiters die geregelte Referenzspannungsquelle (Q1 + $Q_{ref}$; $D_R$) umfasst, die zwischen einem Pol der einen der beiden Betriebsspannungen und einem Betriebsspannungs-Eingang (V-) des Operationsverstärkers (OP) geschaltet ist und zur Regelung einer Referenzspannung ($U_{Ref}$) vorgesehen ist, wobei die geregelte Versorgungs-Kleinspannung ($U_k$) anhand der seriellen Überlagerung der Referenzspannung ($U_{Ref}$) mit der einer der beiden Betriebsspannungen ($U_E$, $U_A$) ausgebildet ist, wobei der Ausgang des Operationsverstärkers zumindest auf 0 Volt oder auch auf eine leicht negative Spannung gebracht wird.

2. Schaltungsanordnung nach Anspruch 1, wobei zwischen dem einen Pol einer Betriebsspannung ($U_A$) und einem Betriebsspannungs-Eingang (V-) des Operationsverstärkers die gesteuerte Arbeitsstrecke (e-c) eines Transistors (Q1) geschaltet ist, wobei an der Steuerelektrode (b) des Transistors eine geregelte Referenzspannungsdiode ($Q_{ref}$) für eine zusätzliche Referenzspannung ($U_R$) liegt.

3. Schaltungsanordnung nach Anspruch 2, wobei der geregelten Referenzspannungsdiode ($Q_{ref}$) zur Einstellung ihrer Führungsgröße die Ausgangsspannung eines Spannungsteilers (R1, R2) zugeführt ist, welcher an der Arbeitsstrecke (e-c) des Transistors (Q1) liegt.

4. Schaltungsanordnung nach Anspruch wobei der Spannungsteiler zusätzlich über einen Vorwiderstand (R4) an jener Betriebsspannung ($U_E$) des Operationsverstärkers (OP) liegt, welche direkt an einem Betriebsspannungs-Eingang (V+) des Operationsverstärkers (OP) liegt.

5. Schaltungsanordnung nach Anspruch 1, wobei die geregelte Referenzspannungsquelle eine geregelte Referenzdiode ($D_R$) ist, die eine interne feste Führungsgröße besitzt.

**Claims**

1. Circuit arrangement for generating a regulated supply extra-low voltage (UK), for an operational amplifier supplied asymmetrically by two operating voltages (UE, UA) and a regulated reference voltage source, comprising the operational amplifier (OP),

   the supply extra-low voltage being of the order of one tenth of one of the two operating voltages, the circuit arrangement further comprising the regulated reference voltage source (Q1 + Qref; DR), which is connected between a pole of one of the two operating voltages and an operating voltage input (V-) of the operational amplifier (OP) and is provided for regulating a reference voltage (URef), the regulated supply extra-low voltage (Uk) being formed on the basis of the serial superposition of the reference voltage (URef) with that of one of the two operating voltages (UE, UA), the output of the operational amplifier being brought at least to 0 volts or also to a slightly negative voltage.

2. Circuit arrangement according to claim 1, wherein the controlled operating path (e-c) of a transistor (Q1) is connected between one pole of an operating voltage (UA) and an operating voltage input (V-) of the operational amplifier, wherein a regulated reference voltage diode (Qref) for an additional reference voltage (UR) is connected to the control electrode (b) of the transistor.

3. Circuit arrangement according to claim 2, wherein the regulated reference voltage diode (Qref) is supplied with the output voltage of a voltage divider (R1, R2) for setting its reference variable, which voltage divider is connected to the working path (e-c) of the transistor (Q1).

4. Circuit arrangement according to claim 3, wherein the voltage divider is additionally connected via a series resistor (R4) to that operating voltage (UE) of the operational amplifier (OP) which is directly connected to an operating voltage input (V+) of the operational amplifier (OP).

5. Circuit arrangement according to claim 1, wherein the regulated reference voltage source is a regulated reference diode (DR) having an internal fixed reference variable.

## Revendications

1. Circuit pour générer une basse tension d'alimentation régulée (UK) pour un amplificateur opérationnel alimenté de manière asymétrique par deux tensions de fonctionnement (UE, UA) et une source de tension de référence régulée, comprenant l'amplificateur opérationnel (OP),

   la très basse tension d'alimentation étant de l'ordre d'un dixième de l'une des deux tensions de fonctionnement,
   où le circuit comprend en outre la source de tension de référence régulée (Q1 + Qref ; DR) qui est connectée entre un pôle de l'une des deux tensions de fonctionnement et une entrée de tension de fonctionnement (V-) de l'amplificateur opérationnel (OP) et qui est prévue pour la régulation d'une tension de référence (URef), la très basse tension d'alimentation régulée (Uk) étant formée à partir de la superposition en série de la tension de référence (URef) avec celle de l'une des deux tensions de fonctionnement (UE, UA), la sortie de l'amplificateur opérationnel étant amenée au moins à 0 volt ou également à une tension légèrement négative.

2. Circuit selon la revendication 1, dans lequel la section de travail commandée (e-c) d'un transistor (Q1) est connectée entre l'un des pôles d'une tension de fonctionnement (UA) et une entrée de tension de fonctionnement (V-) de l'amplificateur opérationnel, une diode de tension de référence régulée (Qref) pour une tension de référence supplémentaire (UR) étant connectée à l'électrode de commande (b) du transistor.

3. Circuit selon la revendication 2, dans lequel la tension de sortie d'un diviseur de tension (R1, R2), qui se trouve sur la section de travail (e-c) du transistor (Q1), est amenée à la diode de tension de référence régulée (Qref) pour régler sa grandeur de commande.

4. Circuit selon la revendication 3, dans lequel le diviseur de tension est en outre relié par l'intermédiaire d'une résistance série (R4) à la tension de fonctionnement (UE) de l'amplificateur opérationnel (OP) qui est directement reliée à une entrée de tension de fonctionnement (V+) de l'amplificateur opérationnel (OP).

5. Circuit selon la revendication 1, dans lequel la source de tension de référence régulée est une diode de référence régulée (DR) qui possède une grandeur de référence fixe interne.

V+ = 5V

E

OP

a

A

V- = 0V

*Fig. 1*

V+ = 2.5V

E

OP

a

A

V- = -2.5V

*Fig. 2*

*Fig. 3*

*Fig. 4*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5097223 A
- WO 0048011 A
- US 2007090878 A